# EUROPÄISCHE PATENTSCHRIFT

(11) **EP 1 173 889 B1**
(45) Veröffentlichungstag und Bekanntmachung des Hinweises auf die Patenterteilung: **28.09.2011**
(21) Anmeldenummer: 00929294.7
(22) Anmeldetag: 14.04.2000
(51) Int. Cl.: H01L 27/02, H01L 29/732

(54) **SCHUTZVORRICHTUNG GEGEN ELEKTROSTATISCHE ENTLADUNGEN**
DEVICE FOR PROTECTING AGAINST ELECTROSTATIC DISCHARGE
DISPOSITIF DE PROTECTION CONTRE LES DECHARGES ELECTROSTATIQUES

(30) Priorität: 16.04.1999 DE 19917155
(43) Veröffentlichungstag der Anmeldung: 23.01.2002
(73) Patentinhaber: ROBERT BOSCH GMBH, 70442 Stuttgart (DE)
(72) Erfinder: METTLER, Stephan, D-72766 Reutlingen (DE); LINDENKREUZ, Steffi, D-72766 Reutlingen (DE); WILKENING, Wolfgang, D-72793 Pfullingen (DE)
(86) Internationale Anmeldenummer: PCT/DE2000/001186
(87) Internationale Veröffentlichungsnummer: WO 2000/063971

(56) Entgegenhaltungen:
- DE-A- 19 746 410
- GB-A- 2 176 053
- US-A- 4 463 369
- US-A- 4 494 134
- US-A- 5 268 588
- US-A- 5 471 082

## Beschreibung

### Stand der Technik

Die Erfindung geht aus von einer Schutzvorrichtung nach der Gattung des unabhängigen Anspruchs. Aus der nach dem Prioritätschatum der vorliegenden Anmeldung veröffentlichten deutschen offentegundschrift DE 197 46 410 A1 ist bereits eine solche Schutzvorrichtung bekannt, bei der im ESD-Fall (ESD ist die Abkürzung für den englischen Ausdruck für elektrostatische Entladung, "electrostatic discharge") eine vertikal angeordnete Transistordiode durch einen lateralen Sperrschichtberührungseffekt (engl. "punch-through effect") durchgeschaltet wird. Bei der dort beschriebenen Schutzvorrichtung jedoch ist die Haltespannung (engl. "snap back voltage"), d.h. die Spannung, die mindestens zwischen Kollektor und Emitter nach dem Durchbruch anliegen muß, damit die Diode durchgeschaltet bleibt, auf einen Wert begrenzt, der im wesentlichen durch die Schichtdicke des Oberflächengebiets der Halbleiteranordnung, in dem die Schutzvorrichtung eingebracht ist, vorgegeben ist.

Aus der US-A-5,471,082 ist eine Schutzvorrichtung gegen elektrostatische Entladungen für eine in einem mittels eines ersten Dotiertyps dotierten Halbleitersubstrat angeordnete integrierte Schaltung bekannt, mit einer vertikal zur Oberfläche des Halbleitersubstrats in einem mittels einem zweiten, dem ersten Dotiertyp entgegen gesetzten Dotiertyps dotierten Oberflächengebiet angeordneten Transistordiode. Die Basis-Emitter-Struktur dieser Transistordiode ist an der Oberfläche eingebracht und deren Kollektor ist als vergrabene und mittels des zweiten Dotiertyps dotierte Schicht ausgebildet. Lateral versetzt zur Transistordiode ist eine mittels des zweiten Dotiertyps dotierte Anschlussschicht zur Kontaktierung der vergrabenen Schicht in das Oberflächengebiet eingebracht, sodass bei Polung der Transistordiode in Sperrrichtung eine Sperrschichtberührung an der Anschluss-Schicht erfolgt bevor ein Durchbruch zwischen Oberflächengebiet und Basis-Emitter-Struktur erfolgen kann.

Die Anschlussschicht ist auf den von der Oberfläche abgewandten Seiten vollständig von Bereichen des Oberflächengebiets umgeben, die eine geringere Dotierung des zweiten Dotiertyps aufweisen als die Anschlussschicht, sodass ein Strompfad zwischen der vergrabenen Schicht und der Anschlussschicht stets über diese Bereiche verlaufen muss. Ein in das Oberflächengebiet eingebrachtes und mittels des zweiten Dotiertyps dotiertes Tiefdiffusionsgebiet, dass mit der vergrabenen Schicht überlappt und bis zur Oberfläche reicht ist zusätzlich vorhanden.

Aus der GB-A-2176053 ist eine weitere Schutzeinrichtung gegen elektrostatische Entladungen für bipolar integrierte Schaltungen bekannt, die eine entsprechend ausgestaltete Halbleiterstruktur aufweist.

### Vorteile der Erfindung

Die erfindungsgemäße Schutzvorrichtung mit den kennzeichnenden Merkmalen des unabhängigen Anspruchs hat infolge einer im inaktiven Zustand der Schutzvorrichtung hochohmigen Kollektoranbindung demgegenüber bei gleichbleibender Durchbruchspannung den Vorteil einer erhöhten Haltespannung. Dadurch können mit in der Halbleiteranordnung integrierte Schaltkreise vor ESD-Pulsen geschützt werden, die mit höheren Spannungen betrieben werden. Wird ein integrierter Schaltkreis beispielsweise mit 25 Volt betrieben, so muß die Haltespannung des Schutzelements größer als 25 Volt sein, damit bei einem ESD-Puls die Betriebsspannung nach Ableitung des ESD-Pulses durch das Schutzelement das Schutzelement nicht in durchgeschaltetem Zustand verharren läßt. Die erfindungsgemäße Anordnung ermöglicht die Bereitstellung eines entsprechenden Schutzelements in platzsparender Weise, da nicht mehr, wie bisher, mehrere Schutzelemente kombiniert werden müssen, um eine ausreichend hohe Haltespannung zu gewährleisten.

Durch die in den abhängigen Ansprüchen aufgeführten Maßnahmen sind vorteilhafte Weiterbildungen und Verbesserungen der im unabhängigen Anspruch angegebenen Schutzvorrichtung möglich.

Das Vorsehen eine Tiefdiffusionsgebiets (einer Sinkerelektrode) dient zum einen als Schutz vor parasitären Strömen und mit ihm wirt zum andern über eine entsprechende Wahl des Abstands zur Anschlußschicht gezielt die Haltespannung der mittels einer vertikal angeordneten Transistordiode realisierten Schutzvorrichtung eingestellt.

### Zeichnung

Ausführungsbeispiele der Erfindung sind in der Zeichnung dargestellt und in der nachfolgenden Beschreibung näher erläutert. Es zeigen Figur 1 eine Schutzvorrichtung, die bereits in der oben zitierten, noch nicht veröffentlichten deutschen Patentanmeldung beschrieben ist, Figur 2 ein Ausführungsbeispiel der Erfindung und Figur 3 ein Strom-Spannungs-Diagramm.

### Beschreibung der Ausführungsbeispiele

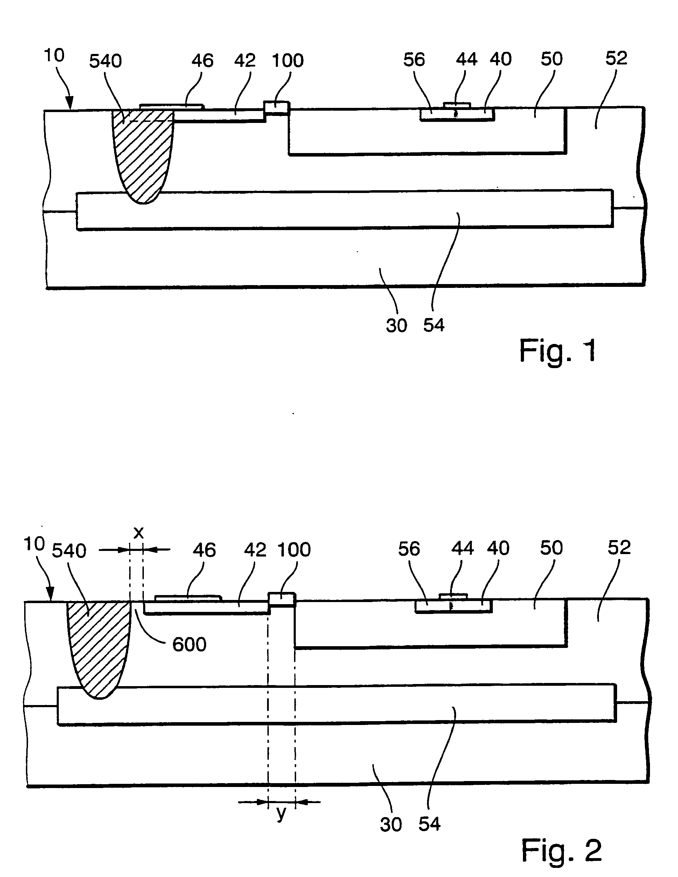

Figur 1 zeigt eine Querschnittsseitenansicht einer Schutzvorrichtung, die auf einem p-dotierten Halbleitersubstrat 30 angeordnet ist. Auf das Substrat 30 ist ein n-dotiertes Oberflächengebiet 52 epitaktisch aufgebracht, wobei zwischen dem Oberflächengebiet und dem Substrat eine stark n-dotierte vergrabene Schicht 54 angeordnet ist. An der Oberfläche 10 des Oberflächengebiets 52 ist eine p-dotierte Wanne 50 eingebracht, in die wiederum ein stark p-dotiertes Gebiet 40 sowie, dazu unmittelbar benachbart, ein stark n-dotiertes Gebiet 56 eingebracht ist, die beide über eine metallische Emitterelektrode 44 an der Oberfläche miteinander elektrisch verbunden sind. Eine an der Oberfläche angeordnete Isolationsoxidschicht 100 trennt die p-Wanne 50 von einer dazu benachbart in die Oberfläche eingebrachten stark n-dotierten Anschlußschicht 42, die über eine Kollektorelektrode 46 elektrisch kontaktiert werden kann. Die Anschlußschicht 42 überlappt mit einer in das Oberflächengebiet 52 eingebrachten stark n-dotierten Sinkerelektrode 540, die wiederum teilweise mit der vergrabenen Schicht 54 überlappt. Die Dotierung der p-Wanne 50 liegt typischerweise in einem Bereich von 10¹⁷ cm³. Die n-Dotierung des Oberflächengebiets 52 liegt typischerweise in einem Bereich von 10¹⁵ cm⁻³, die Dotierung der stark n-dotierten Anschlußschicht 42 in einem Bereich von typischerweise 10¹⁹ cm⁻³.

Für den Einsatz einer derartigen Vorrichtung als ESD-Schutz ist die Sperrpolung des pn-Übergangs zwischen der p-Wanne 50 und dem Oberflächengebiet 52 relevant. Der Abstand zwischen der p-Wanne und der Anschlußschicht 42 ist derart dimensioniert, daß die mit zunehmender Sperrspannung wachsende Verarmungszone im Oberflächengebiet 52 die Anschlußschicht 42 erreicht, bevor die Durchbruchspannung zwischen der p-Wanne 50 und dem Oberflächengebiet 52 erreicht ist. Somit erfolgt zwischen der Wanne 50 und der Anschlußschicht 42 ein Durchbruch infolge des Sperrschichtberührungseffekts.

Figur 2 zeigt ein Ausführungsbeispiel der erfindungsgemäßen Schutzvorrichtung. Gleiche Bezugszeichen wie in Figur 1 bezeichnen gleiche oder ähnliche Bestandteile und werden im folgenden nicht nochmals beschrieben. Die Anschlußschicht 42 ist beabstandet zur p-Wanne 50 angeordnet; der Abstand ist mit "y" markiert. Darüberhinaus ist die Anschlußschicht 42 beabstandet zur Sinkerelektrode 540 angeordnet; der entsprechende Abstand ist mit "x" markiert. x ist hierbei eine positive Größe, das heißt die Anschlußschicht 42 und die Sinkerelektrode überlappen nicht, vielmehr befindet sich im Verlauf der Dotierkonzentration entlang der Oberfläche von der Sinkerelektrode hin zu der Anschlußschicht 42 ein lokales Minimum, das durch das Zwischengebiet 600 gebildet wird, das Teil des Oberflächengebiets 52 ist.

Durch die p-Wanne 50 als Basis, die über das stark p-dotierte Gebiet 40 und die Emitterelektrode 44 mit dem als Emitter fungierenden stark n-dotierten Gebiet 56 kurzgeschlossen ist, und der vergrabenen Schicht 54 als Kollektor wird eine Transistordiode (Dreischichtdiode) gebildet. Die elektrische Anbindung des Kollektors über die Kollektorelektrode 46 erfolgt mittels der stark n-dotierten Anschlußschicht 42. Zur Verwendung als ESD-Schutz wird die Transistordiode in Sperrichtung gepolt, also beispielsweise das Massepotential an die Emitterelektrode 44 und das positive Potential eines gegen elektrostatische Entladungen zu schützenden Anschlusses eines benachbarten integrierten Schaltkreises an die Kollektorelektrode 46 gelegt. Solange die Potentialdifferenz zwischen den Elektroden unterhalb der Durchbruchspannung liegt, sperrt die Transistordiode (analog zur Anordnung nach Figur 1). Ferner ist die Anschlußschicht 42 nur sehr hochohmig mit der vergrabenen Schicht verbunden, da jeder mögliche Strompfad zwischen der Anschlußschicht und der vergrabenen Schicht durch das (relativ zur vergrabenen Schicht und zur Anschlußschicht schwach dotierte) Oberflächengebiet verläuft. Dies führt jedoch dazu, daß im Falle eines Durchbruchs die Transistordiode eine im Vergleich zur Anordnung nach Figur 1 erhöhte Haltespannung aufweist. Über den Abstand x der Anschlußschicht zur Sinkerelektrode ist der Wert der Haltespannung einstellbar, er nimmt mit größer werdendem x zu. Die Durchbruchspannung ist weitgehend unabhängig von der Haltespannung und ebenfalls wählbar durch entsprechende Auslegung des Abstands y.

Die Sinkerelektrode 540 dient dazu, die Schutzvorrichtung gegen andere Schaltkreise abzugrenzen und so parasitäre Effekte beziehungsweise Leckströme ins Substrat zu unterbinden. Entsprechende Vorrichtungen wie in Figur 2 beschrieben sind auch mit vertauschten Dotierungen realisierbar.

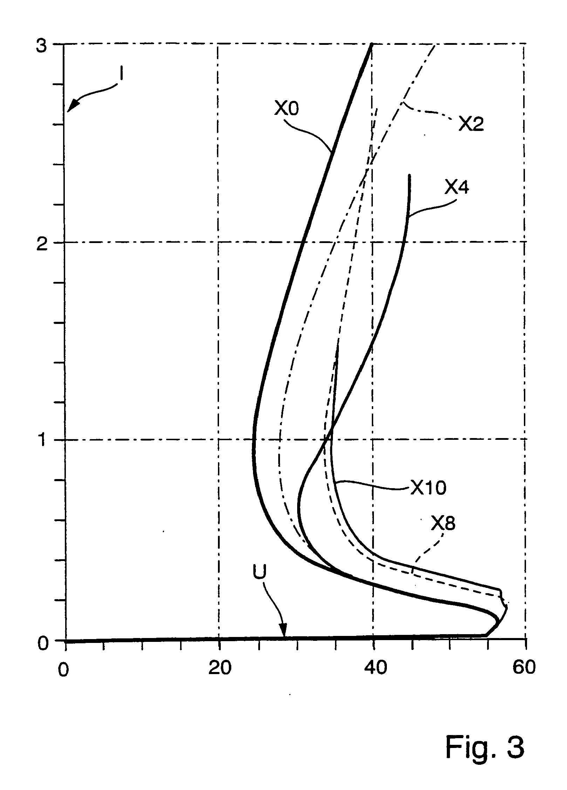

Figur 3 zeigt ein Diagramm des Stroms I in willkürlichen Einheiten zwischen Kollektorelektrode 46 und Emitterelektrode 44 in Abhängigkeit von der elektrischen Spannung in Volt zwischen diesen Elektroden. Die Kurve x0 charakterisiert eine Anordnung gemäß Figur 1, die Kurven x2, x4, x8 und x10 die erfindungsgemäße Anordnung gemäß Figur 2, wobei die Ziffern hinter dem x jeweils den Abstand der Anschlußschicht 42 von der Sinkerelektrode 540 in Mikrometern angeben. Sobald die Spannung den Wert von zirka 57 Volt erreicht, werden alle Anordnungen in Sperrichtung niederohmig, wobei durch das relative Minimum der Spannung nach dem Durchbruch die Haltespannung gegeben ist. Im Falle der Anordnung nach Figur 1 beträgt die Haltespannung zirka 25 Volt. Für x größer als Null ist die Haltespannung erhöht, die Durchbruchspannung bleibt, wie gesagt, weitgehend gleich. Für große x sind kaum noch Unterschiede erkennbar, der Grenzfall maximaler Haltespannung bei ausschließlicher Variation von x ist also durch das Weglassen der Sinkerelektrode gegeben.

Die erhöhte Haltespannung erklärt sich durch die hochohmige Anbindung der vergrabenen Schicht an die Anschlußschicht. Die Transistorfunktion ist also eigentlich beeinträchtigt, was aber für die Funktion als ESD-Schutzelement unerheblich ist, da beim Durchschalten der Anordnung in Sperrichtung das Oberflächengebiet von Ladungsträgern überschwemmt und somit niederohmig wird. Dies wird durch einen zusätzlich auftretenden Avalanche-Effekt zwischen Anschlußschicht und Oberflächengebiet unterstützt, der zusätzliche Ladungsträger generiert. Die neuartige Schutzvorrichtung weist also einen stark stromabhängigen Kollektorwiderstand auf, der im "richtigen" Zeitpunkt, d.h. zum Zeitpunkt des Durchbruchs, also wenn die Schutzfunktion aktiviert wird, niederohmig wird, um eine Ableitung eines ESD-Pulses zu gewährleisten. Bei großen Abständen zwischen Sinkerelektrode und Anschlußschicht (8 bzw. 10 Mikrometer) tritt der Avalanche-Effekt zwischen Anschlußschicht und Oberflächengebiet klar hervor: die betreffenden Kennlinien zeigen im Hochstrombereich eine kleinere Steigung als im Falle x=0, d.h. der Hochstromwiderstand der Kollektoranbindung ist dann sogar erniedrigt im Vergleich zu einer Anordnung, bei der die vergrabene Schicht relativ niederohmig über die Sinkerelektrode mit der Anschlußschicht verbunden ist.

## Patentansprüche

1. Schutzvorrichtung gegen elektrostatische Endadungen, für eine in einem mittels eines ersten Dotiertyps dotierten Halbleitersubstrat (30) angeordnete integrierte Schaltung, mit einer vertikal zur Oberfläche (10) des Halbleitersubstrats in einem mittels eines zweiten, dem ersten Dotiertyps entgegengesetzten Dotiertyps dotierten Oberflächengebiet (52) angeordneten Transistordiode (44,56,40,50,52,54), wobei deren Basis-Emitter-Struktur (44,56,40,50) an der Oberfläche eingebracht und deren Kollektor als vergrabene und mittels des zweiten Dotiertyps dotierte Schicht (54) ausgebildet ist, wobei lateral versetzt (y) zur Transistordiode eine mittels des zweiten Dotiertyps dotierte Anschlußschicht (42) zur Kontaktierung der vergrabenen Schicht (54) in das Oberflächengebiet (52) eingebracht ist, so daß bei Polung der Transistordiode in Sperrichtung eine Sperrschichtberührung (engl. "punchthrough") an der Anschlußschicht (42) erfolgt, bevor ein Durchbruch zwischen Oberflächengebiet (52) und Basis-Emitter-Struktur (44,56,40,50) erfolgen kann, wobei die Anschlußschicht (42) auf den von der Oberfläche abgewandten Seiten vollständig von Bereichen des Oberflächengebiets umgeben ist, die eine geringere Dotierung des zweiten Dotiertyps aufweisen als die Anschlußschicht (42), so daß ein Strompfad zwischen der vergrabenen Schicht (54) und der Anschlußschicht (42) stets über die Bereiche verlaufen muß, wobei ein in das Oberflächengebiet (52) eingebrachtes und mittels des zweiten Dotiertyps dotiertes Tiefdiffusionsgebiet (540), das mit der vergrabenen Schicht (54) überlappt und bis zur Oberfläche reicht, vorgesehen ist, **dadurch gekennzeichnet, dass** ein von Null verschiedener Abstand (x) zwischen dem Tiefdiffusionsgebiet (540) und der Anschlußschicht (42) entsprechend der zu erzielenden Haltespannung ("snap-back voltage") der Transistordiode bemessen ist und das Tiefdiffusionsgebiet (540) stärker dotiert ist als das Oberflächengebiet (52).

2. Schutzvorrichtung nach Anspruch 1, **dadurch gekennzeichnet, daß** der Abstand (y) zwischen der Anschlußschicht (42) und der Basis-Emitter-Struktur entsprechend der zu erzielenden Durchbruchsspannung der Transistordiode bemessen ist.

3. Schutzvorrichtung nach einem der vorhergehenden Ansprüche, **dadurch gekennzeichnet, daß** das Halbleitersubstrat (30) p-dotiert ist, wobei das Oberflächengebiet (52) als n-dotierte epitaktische Schicht ausgebildet ist.

4. Schutzvorrichtung nach Anspruch 3, **dadurch gekennzeichnet, daß** die Basis-Emitter-Struktur (44,56,40,50) eine die Basis der Transistordiode bildende, in das Oberflächengebiet (52) eingebrachte p-dotierte Wanne (50) aufweist.

5. Schutzvorrichtung nach Anspruch 4, **dadurch gekennzeichnet, daß** in die p-dotierte Wanne ein stark p-dotiertes Gebiet (40) zur Kontaktierung der p-Wanne sowie ein stark n-dotiertes Gebiet (56) eingebracht sind, wobei die beiden Gebiete (40, 56) miteinander über eine metallische Leitung, insbesondere über eine an der Oberfläche aufgebrachte Emitterelektrode (44), in elektrischer Verbindung stehen.

6. Schutvorrichtung nach einem der Ansprüche 3, 4 oder 5, **dadurch gekennzeichnet, daß** die vergrabene Schicht (54) stark n-dotiert und zwischen dem Substrat (30) und dem Oberflächengebiet (52) angeordnet ist, wobei sie sich zumindest unterhalb der Basis-Emitter-Struktur erstreckt.

7. Schutzvorrichtung nach Anspruch 6, **dadurch gekennzeichnet, daß** sich die vergrabene Schicht auch unterhalb der Anschlußschicht (42) erstreckt.

8. Schutzvorrichtung nach einem der Ansprüche 3 bis 7, **dadurch gekennzeichnet, daß** die Anschlußschicht (42) stark n-dotiert ist.

9. Schutzvorrichtung nach einem der Absprüche 3 bis 8, **dadurch gekennzeichnet, daß**, das Tiefdiffusionsgebiet (540) stark n-dotiert ist.

10. Schutzvorrichtung nach einem der Ansprüche 3 bis 9, **gekennzeichnet durch** vertauschte Dotierungen.

## Claims

1. Device for protection against electrostatic discharges, for an integrated circuit arranged in a semiconductor substrate (30) doped by means of a first doping type, comprising a transistor diode (44, 56, 40, 50, 52, 54) arranged vertically with respect to the surface (10) of the semiconductor substrate in a surface region (52) doped by means of a second doping type, which is opposite to the first doping type, wherein the base-emitter structure (44, 56, 40, 50) of said transistor diode is introduced at the surface and the collector of said transistor diode is embodied as a buried layer (54) doped by means of the second doping type, wherein a connection layer (42) doped by means of the second doping type and serving for making contact with the buried layer (54) is introduced into the surface region (52) in a manner laterally offset (y) with respect to the transistor diode, such that, when the transistor diode is reverse-biased, a punchthrough takes place at the connection layer (42) before a breakdown can take place between the surface region (52) and base-emitter structure (44, 56, 40, 50) wherein the connection layer (42), on the sides remote from the surface, is surrounded completely by regions of the surface region which have a lower doping of the second doping type than the connection layer (42) such that a current path between the buried layer (54) and the connection layer (42) always has to run via the regions, wherein a deep diffusion region (540) = introduced into the surface region (52) and doped by means of the second doping type is provided, said deep diffusion region overlapping the buried layer (54) and extending as far as the surface, **characterized in that** a distance (x) that differs from zero between the deep diffusion region (540) and the connection layer (42) is dimensioned in accordance with the snap-back voltage to be obtained of the transistor diode and the deep diffusion region (540) is more heavily doped than the surface region (52).

2. Device for protection according to Claim 1, **characterized in that** the distance (y) between the connection layer (42) and the base-emitter structure is dimensioned in accordance with the breakdown voltage of the transistor diode that is to be obtained.

3. Device for protection according to either of the preceding claims, **characterized in that** the semiconductor substrate (30) is p-doped, wherein the surface region (52) is embodied as an n-doped epitaxial layer.

4. Device for protection according to Claim 3, **characterized in that** the base-emitter structure (44, 56, 40, 50) has a p-doped well (50), which forms the base of the transistor diode and is introduced into the surface region (52).

5. Device for protection according to Claim 4, **characterized in that** a heavily p-doped region (40) for making contact with the p-doped well and a heavily n-doped region (56) are introduced into the p-doped well, wherein the two regions (40, 56) are electrically connected to one another via a metallic line, in particular via an emitter electrode (44) applied to the surface.

6. Device for protection according to any of Claims 3, 4 or 5, **characterized in that** the buried layer (54) is heavily n-doped and is arranged between the substrate (30) and the surface region (52), wherein it extends at least below the base-emitter structure.

7. Device for protection according to Claim 6, **characterized in that** the buried layer also extends below the connection layer (42).

8. Device for protection according to any of Claims 3 to 7, **characterized in that** the connection layer (42) is heavily n-doped.

9. Device for protection according to any of Claims 3 to 8, **characterized in that** the deep diffusion region (540) is heavily n-doped.

10. Device for protection according to any of Claims 3 to 9, **characterized by** interchanged dopings.

## Revendications

1. Dispositif de protection contre des décharges électrostatiques destiné à un circuit intégré disposé dans un substrat semi-conducteur (30) dopé avec un premier type de dopage, comprenant un transistor-diode (44, 56, 40, 50, 52, 54) disposé perpendiculairement à la surface (10) du substrat semi-conducteur dans une région de surface (52) dopée avec un second type de dopage opposé au premier type de dopage, dans lequel sa structure de base-émetteur (44, 56, 40, 50) est mise en place sur la surface et son collecteur est réalisé sous la forme d'une couche (54) enterrée et dopée avec le second type de dopage, dans lequel une couche de connexion (42) dopée avec le second type de dopage est mise en place de manière décalée latéralement (y) vers le transistor-diode pour la connexion à la couche enterrée (54) dans la région de surface (52), de telle sorte que lors de la polarisation du transistor-diode dans la direction de la barrière, il se produit un contact de couche barrière (en anglais "punchthrough") avec la couche de connexion (42) avant qu'un claquage puisse se produire entre la région de surface (52) et la structure de base-émetteur (44, 56, 40, 50), dans lequel la couche de connexion (42), du côté opposé à la surface, est entièrement entourée de zones de la région de surface qui sont plus faiblement dopées avec le second type de dopage que la couche de connexion (42), de telle sorte qu'un trajet de courant soit toujours établi entre la couche enterrée (54) et la couche de connexion (42) par l'intermédiaire de ces zones, dans lequel il est prévu une région de diffusion profonde (540) mise en place dans la région de surface (52) et dopée avec le second type de dopage qui chevauche la couche enterrée (54) et se prolonge jusqu'à la surface, **caractérisé en ce qu'**on mesure une distance non nulle (x) entre la région de diffusion profonde (540) et la couche de connexion (42), laquelle distance correspond à la tension de maintien devant être obtenue ("snap-back voltage") dans le transistor-diode, et **en ce que** la région de diffusion profonde (540) est plus fortement dopée que la région de surface (52).

2. Dispositif de protection selon la revendication 1, dans lequel on mesure la distance (y) entre la couche de connexion (42) et la structure de base-émetteur correspondant à la tension de claquage devant être obtenue dans le transistor-diode.

3. Dispositif de protection selon l'une des revendications précédentes, **caractérisé en ce que** le substrat semi-conducteur (30) est dopé p, dans lequel la région de surface (52) est réalisée sous la forme d'une couche épitaxiale dopée n.

4. Dispositif de protection selon la revendication 3, **caractérisé en ce que** la structure de base-émetteur (44, 56, 40, 50) présente un puits (50) dopé p mis en place dans la région de surface (52) et formant la base du transistor-diode.

5. Dispositif de protection selon la revendication 4, **caractérisé en ce que** dans le puits dopé p sont mises en place une région fortement dopée p (40) pour la connexion du puits p ainsi qu'une région fortement dopée n (56), dans lequel les deux régions (40, 56) sont reliées l'une à l'autre par l'intermédiaire d'un conducteur métallique, notamment par l'intermédiaire d'une électrode d'émetteur (44) mise en place sur la surface.

6. Dispositif de protection selon l'une quelconque des revendications 3, 4 ou 5, **caractérisé en ce que** la couche enterrée (54) est fortement dopée n et est disposée entre le substrat (30) et la région de surface (52), dans lequel celle-ci s'étend au moins en dessous de la structure de base-émetteur.

7. Dispositif de protection selon la revendication 6, **caractérisé en ce que** la couche enterrée s'étend également en dessous de la couche de connexion (42).

8. Dispositif de protection selon l'une des revendications 3 à 7, **caractérisé en ce que** la couche de connexion (42) est fortement dopée n.

9. Dispositif de protection selon l'une des revendications 3 à 8, **caractérisé en ce que** la région de diffusion profonde (540) est fortement dopée n.

10. Dispositif de protection selon l'une des revendications 3 à 9, **caractérisé par** des dopages inversés.
